# EUROPEAN PATENT APPLICATION

(11) **EP 3 582 223 A1**
(43) Date of publication of application: **18.12.2019**
(21) Application number: 18206579.7
(22) Date of filing: 15.11.2018
(51) Int. Cl.: G11C 11/406

(54) **MEMORY DEVICE AND OPERATING METHOD THEREOF**

(30) Priority: 11.06.2018 US 201816005662
(71) Applicant: Nanya Technology Corporation, 243 New Taipei City (TW)
(72) Inventor: CHANG, Chuan-Jen, 308 Hsinchu County (TW); LEE, Wen-Ming, 351 Miaoli County (TW)
(74) Representative: dompatent von Kreisler Selting Werner - Partnerschaft von Patent- und Rechtsanwälten mbB

(57) **Abstract**

An operating method of a memory device includes the following operations: detecting a first temperature of the memory device; determining a first refresh rate according to the first temperature; and refreshing the memory device by the first refresh rate. The first refresh rate is lower than a refresh rate upper threshold.

## Description

### BACKGROUND

### Technical Field

The present disclosure relates to memory technology. More particularly, the present disclosure relates to a memory device and an operating method thereof.

### Description of Related Art

Data stored in the memory array are more likely to loss when the temperature of the memory device is higher. Therefore, higher refresh rate is needed when the temperature of the memory device becomes higher. However, higher refresh rate causes higher power consumption.

### SUMMARY

An aspect of the present disclosure is to provide an operating method of a memory device. The operating method includes the following operations: detecting a first temperature of the memory device; determining a first refresh rate according to the first temperature; and refreshing the memory device by the first refresh rate. The first refresh rate is lower than a refresh rate upper threshold.

Another aspect of the present disclosure is to provide a memory device. The memory device includes a temperature sensor, a memory array, and a controller. The temperature sensor is configured to detect a first temperature of the memory device. The controller is configured to determine a first refresh rate according to the first temperature and to refresh the memory array by the first refresh rate. The first refresh rate is lower than a refresh rate upper threshold.

In sum, the refresh rate determined by the controller in the present disclosure is lower than the refresh rate of the JEDEC SPEC regardless of the temperature. Therefore, the power consumption in the present disclosure becomes lower.

### BRIEF DESCRIPTION OF THE DRAWINGS

The present disclosure can be more fully understood by reading the following detailed description of the embodiment, with reference made to the accompanying drawings as follows:
Fig. 1 is a schematic diagram of a memory device according to some embodiments of the present disclosure;
Fig. 2 is an experimental chart of a memory device according to some embodiments of the present disclosure.
Fig. 3 is a pulse diagram of a memory device according to some embodiments of the present disclosure.
Fig. 4 is an operating method of a memory device according to some embodiments of the present disclosure.

### DETAILED DESCRIPTION

In order to make the description of the disclosure more detailed and comprehensive, reference will now be made in detail to the accompanying drawings and the following embodiments. However, the provided embodiments are not used to limit the ranges covered by the present disclosure; orders of step description are not used to limit the execution sequence either. Any devices with equivalent effect through rearrangement are also covered by the present disclosure.

The terminology used herein is for the purpose of describing particular embodiments only and is not intended to be limiting of the disclosure. As used herein, the singular forms "a," "an" and "the" are intended to include the plural forms as well, unless the context clearly indicates otherwise. It will be further understood that the terms "comprises" and/or "comprising," or "includes" and/or "including" or "has" and/or "having" when used in this specification, specify the presence of stated features, regions, integers, steps, operations, elements, and/or components, but do not preclude the presence or addition of one or more other features, regions, integers, steps, operations, elements, components, and/or groups thereof.

In this document, the term "coupled" may also be termed as "electrically coupled," and the term "connected" may be termed as "electrically connected." "Coupled" and "connected" may also be used to indicate that two or more elements cooperate or interact with each other.

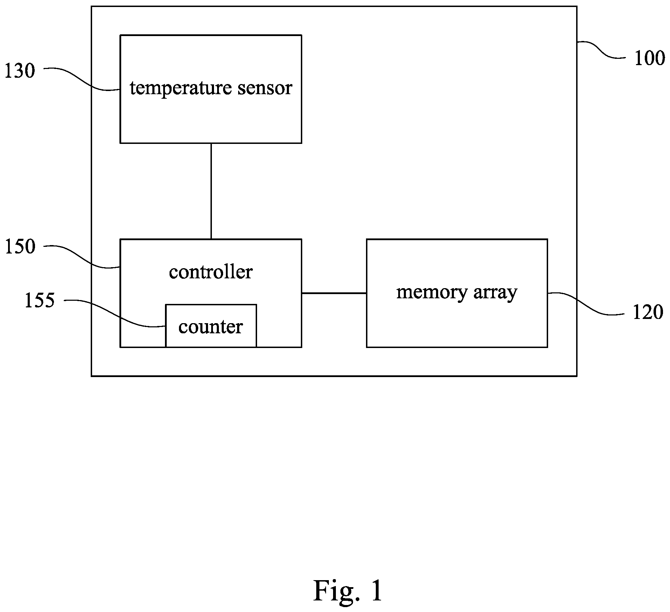

Reference is made to Fig. 1. Fig. 1 is a schematic diagram of a memory device 100 according to some embodiments of the present disclosure. The memory device 100 includes a memory array 120, a temperature sensor 130, and a controller 150. In some embodiments, the temperature sensor 130 is coupled to the controller 150. The controller 150 is coupled to the memory array 120.

In the operation relationship, the temperature sensor 130 is configured to detect a temperature of the memory device 100. The controller 150 is configured to determine a refresh rate according to the detected temperature. Then, the controller 150 refreshes the memory array 120 by the determined refresh rate. The determined refresh rate is lower than a refresh rate upper threshold. In some embodiments, the refresh rate upper threshold is the refresh rate determined by the JEDEC (Joint Electron Device Engineering Council, JEDEC) spec.

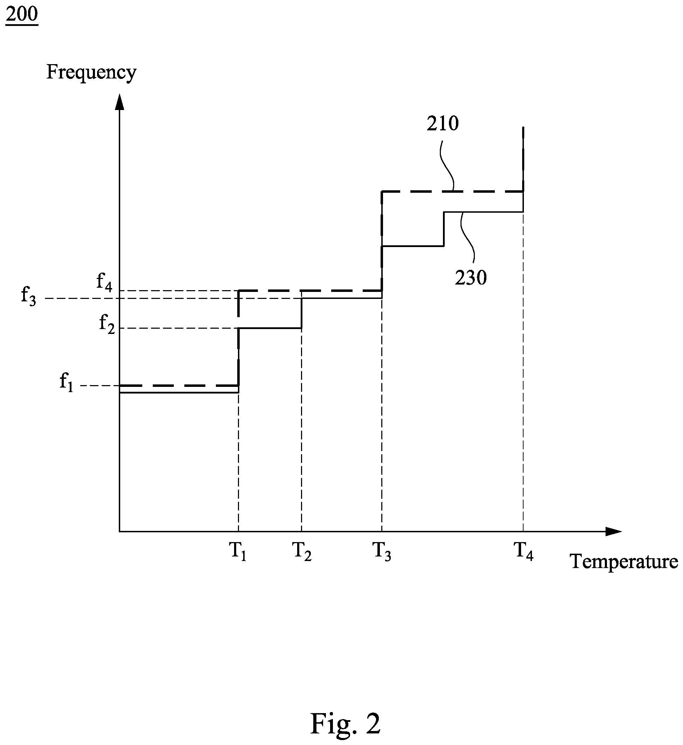

Reference is made to Fig. 2. Fig. 2 is an experimental chart 200 of a memory device 100 according to some embodiments of the present disclosure. Curve 210 represents the relationship between the refresh rate and the temperature according to the JEDEC spec. Curve 230 represents the relationship between the refresh rate and the temperature according to the present disclosure.

As illustrated in Fig. 2, when the detected temperature is lower than T3 and higher than T1, the refresh rate of JEDEC spec is f4. However, in the present disclosure, when the detected temperature is lower than T2 and higher than T1, the refresh rate is f2, which is lower than f4. Moreover, in the present disclosure, when the detected temperature is lower than T3 and higher than T2, the refresh rate is f3, which is also lower than f4.

As illustrated in Fig. 2, when the detected temperature is higher, the determined refresh rate is higher.

It should be noted that the determined refresh rate in the present disclosure are within the retention of the memory device 100.

Reference is made to Fig. 1 again. In some embodiments, the temperature sensor 130 is further configured to transmit the temperature to the controller 150 by a digital command. For example, when the detected temperature is lower than 20 Celsius degrees, the temperature sensor 130 transmits a digital command with 0000 to the controller 150. When the detected temperature is lower than 25 Celsius degrees and higher the 20 Celsius degrees, the temperature sensor 130 transmits a digital command with 0001 to the controller 150. The digital command mentioning above are for illustrative purposes only, and the present disclosure is not limited thereto.

In some embodiments, the controller 150 is further configured to transmit a refresh command by the refresh rate to the memory array 120, and the memory array 120 refreshes when receiving the refresh command. For example, if it is determined by the controller 150 that the refresh rate is f1 Hz(Hertz), the controller 150 transmits a refresh command to the memory array 120 every 1/f1 second. Whenever the memory array 120 receives the refresh command, the memory array 120 refreshes.

In some embodiments, the controller 150 further comprises a counter 155. The counter 155 is configured to receive an oscillator signal and to generate the refresh command according to a pulse number of the oscillator signal and the determined refresh rate.

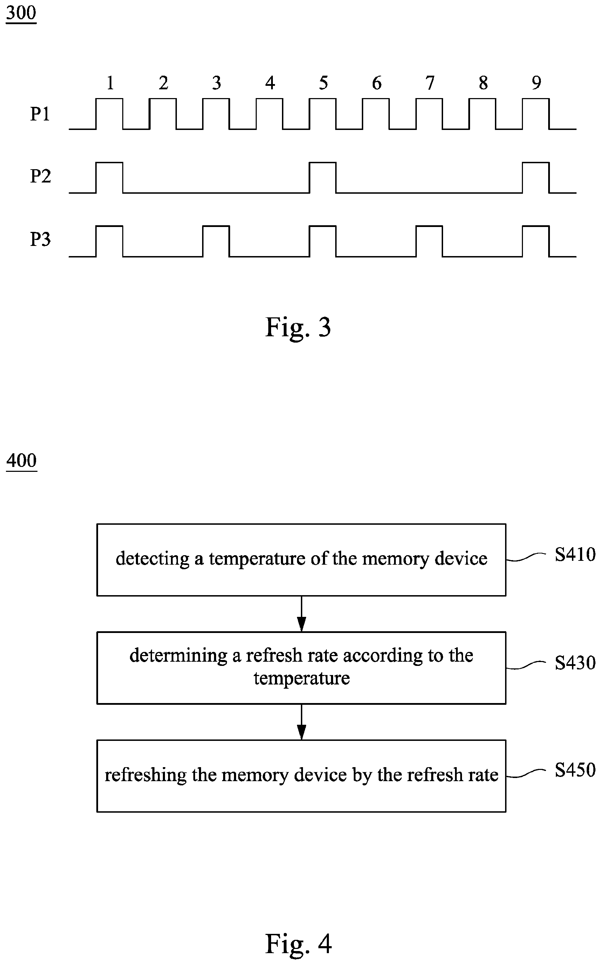

Reference is made to Fig. 1 and Fig. 3 at the same time. Fig. 3 is a pulse diagram 300 of a memory device 100 according to some embodiments of the present disclosure. P1 is a pulse curve generated by an oscillator (not shown) with a frequency of f1. Assume that the counter 155 receives the oscillator signal of the pulse curve PI, and the refresh rate determined by the controller 150 according to the detected temperature is the refresh rate with a frequency of f2, in which f2 is 1/4 of f1. P2 is a pulse curve generated by the controller 150 when the determined refresh rate is f2.

To be more detailed, the counter 155 counts the pulse number of the oscillator signal, and the controller 150 generates a refresh command whenever the counter 155 receives four pulses of the oscillator signal. That is, the controller 150 generates the refresh command when the first, fifth, ninth pulses are received by the counter 155, and so on, as shown in P2. Since the controller 150 transmits the refresh command to the memory array 120 when generating the refresh command, the memory array 120 receives the refresh command with the refresh rate of f2, and the memory array 120 refreshes with the refresh rate of f2.

Similarly, Assume that the counter 155 receives the oscillator signal of the pulse curve PI, and the refresh rate determined by the controller 150 according to the detected temperature is the refresh rate with a frequency of f4, in which f4 is 1/2 of f1. P3 is a pulse curve generated by the controller 150 when the determined refresh rate is f4.

To be more detailed, the counter 155 counts the pulse number of the oscillator signal, and the controller 150 generates a refresh command whenever the counter 155 receives two pulses of the oscillator signal. That is, the controller 150 generates the refresh command when the first, third, fifth, seventh, ninth pulses are received by the counter 155, and so on, as shown in P3. Since the controller 150 transmits the refresh command to the memory array 120 when generating the refresh command, the memory array 120 receives the refresh command with the refresh rate of f4, and the memory array 120 refreshes with the refresh rate of f4.

In some embodiments, the oscillator (not shown) may be implemented in the memory device 100.

Reference is made to Fig. 4. Fig. 4 is an operating method 400 of a memory device 100 according to some embodiments of the present disclosure. The operating method 400 includes the following operations:
S410: detecting a temperature of the memory device;
S430: determining a refresh rate according to the temperature; and
S450: refreshing the memory device by the refresh rate.

For convenience of explanation and understanding, reference is made to Fig. 1 and Fig. 4. These operations are given for illustrative purposes. Additional operations are within the contemplated scoped of the present disclosure.

In operation S410, detecting a temperature of the memory device. In some embodiments, the temperature sensor 130 performs operation S410. For example, temperature sensor 130 detects a temperature of the memory device 100. In some embodiments, the temperature sensor 130 transmits the detected temperature to the controller 150 by a digital command. For example, when the detected temperature is lower than 20 Celsius degrees, the temperature sensor 130 transmits a digital command with 0000 to the controller 150.

In operation S430, determining a refresh rate according to the temperature. In some embodiments, the controller 150 performs operation S430. For example, the controller 150 determines a refresh rate according to the detected temperature transmitted from the temperature sensor 130. The determined refresh rate is lower than a refresh rate upper threshold. In some embodiments, the refresh rate upper threshold is the refresh rate determined by the JEDEC spec. In some embodiments, the higher the detected temperature is, the higher the determined refresh rate is. It should be noted that the determined refresh rate in the present disclosure are within the retention of the memory device 100. That is, the determined refresh rate should not be too low.

In some embodiments, after determining the refresh rate, the controller 150 transmits a refresh command by the determined refresh rate to the memory array 120.

In operation S450, refreshing the memory device by the refresh rate. In some embodiments, the controller 150 performs operation S450. For example, if it is determined by the controller 150 that the refresh rate is f1 Hz (Hertz), the controller 150 transmits a refresh command to the memory array 120 every 1/f1 second. Whenever the memory array 120 receives the refresh command, the memory array 120 refreshes.

In some embodiments, operation method 400 further comprises the following operations: receiving an oscillator signal; and generating the refresh command according to a pulse number of the oscillator signal and the refresh rate. For example, the counter 155 receives an oscillator signal and generates the refresh command according to a pulse number of the oscillator signal and the determined refresh rate.

Reference is made to Fig. 3 at the same time. P1 is a pulse curve generated by an oscillator (not shown) with a frequency of f1. Assume that the counter 155 receives the oscillator signal of the pulse curve PI, and the refresh rate determined by the controller 150 according to the detected temperature is the refresh rate with a frequency of f2, in which f2 is 1/4 of f1. P2 is a pulse curve generated by the controller 150 when the determined refresh rate is f2. The counter 155 counts the pulse number of the oscillator signal, and the controller 150 generates a refresh command whenever the counter 155 receives four pulses of the oscillator signal. That is, the controller 150 generates the refresh command when the first, fifth, ninth pulses are received by the counter 155, and so on, as shown in P2. Since the controller 150 transmits the refresh command to the memory array 120 when generating the refresh command, the memory array 120 receives the refresh command with the refresh rate of f2, and the memory array 120 refreshes with the refresh rate of f2.

It should be noted that, any of the determined refresh rate that is lower than the refresh rate determined by the JEDEC spec and is within the retention of the memory array 120 is within the consideration of the present disclosure.

As a result, the refresh rate determined by the controller 150 in the present disclosure may be lower than the refresh rate of the JEDEC SPEC regardless of the temperature. Therefore, the power consumption in the present disclosure becomes lower.

In some embodiments, the controller 150 may be a circuit, a central processing unit, a central processing unit (CPU), a microprocessor (MCU), or other device having the function of storing, calculating, data reading, signal or information receiving, signal or information transmitting, or other equivalent functionality. In some embodiments, the temperature detector 130 may be a circuit or an element having the function of temperature detecting or other equivalent functionality. In some embodiments, the memory array 120 may be a circuit or an element having the function of data storing or other equivalent functionality. In some embodiments, the memory array 120 includes several memory rows and several memory columns for storing data. In some embodiments, the counter 155 may be a circuit or an element having the function of counting, signal or information receiving, signal or information transmitting, or other equivalent functionality. In some embodiments, the memory device 100 may be implemented as a read-only memory, a flash memory, a floppy disk, a hard disk, an optical disk, a flash disk, a tape, a database or a storage medium having the same function that people in the art can easily think of.

## Claims

1. An operating method (400) of a memory device, comprising:
detecting a first temperature of the memory device (S410);
determining a first refresh rate according to the first temperature (S430); and
refreshing the memory device by the first refresh rate (S450);
wherein the first refresh rate is lower than a refresh rate upper threshold.

2. The operating method of claim 1, further comprising:
transmitting the first temperature to a controller by a digital command.

3. The operating method (400) of claim 1, further comprising:
determining a second refresh rate according to a second temperature;
wherein the second temperature is higher than the first temperature, and the second refresh rate is higher than the first refresh rate.

4. The operating method (400) of claims 1 or 2, further comprising:
transmitting a refresh command with the first refresh rate to the memory device.

5. The operating method (400) of claim 4, further comprising:
receiving an oscillator signal;
generating the refresh command according to a pulse number of the oscillator signal and the first refresh rate.

6. A memory device (100), comprising:
a temperature sensor (130), configured to detect a first temperature of the memory device (100);
a memory array (120); and
a controller (150), configured to determine a first refresh rate according to the first temperature and to refresh the memory array (120) by the first refresh rate;
wherein the first refresh rate is lower than a refresh rate upper threshold.

7. The memory device (100) of claim 6, wherein the temperature sensor is further configured to transmit the first temperature to the controller (150) by a digital command.

8. The memory device (100) of claims 6 or 7, wherein the controller (150) is further configured to determine a second refresh rate according to a second temperature, wherein the second temperature is higher than the first temperature, and the second refresh rate is higher than the first refresh rate.

9. The memory device (100) of any of claims 6 to 8, wherein the controller (150) is further configured to transmit a refresh command with the first refresh rate to the memory array (120).

10. The memory device (100) of claim 9, wherein the controller (150) further comprises:
a counter (155), configured to receive an oscillator signal;
wherein the controller (150) is further configured to generate the refresh command according to a pulse number of the oscillator signal and the first refresh rate.
